# EUROPÄISCHE PATENTANMELDUNG

(11) **EP 1 582 572 A1**
(43) Veröffentlichungstag der Anmeldung: **05.10.2005**
(21) Anmeldenummer: 05006693.5
(22) Anmeldetag: 26.03.2005
(51) Int. Cl.: C09J 7/02, C09J 5/06, C09J 121/00, C09J 11/02, C08K 5/40, B32B 25/12, B32B 25/14, B32B 25/08

(54) **Klebemittel für Fügeverbindungen**

(30) Priorität: 02.04.2004 DE 102004016308
(71) Anmelder: Henkel Kommanditgesellschaft auf Aktien, 40589 Düsseldorf (DE); Volkswagen AG, 38436 Wolfsburg (DE)
(72) Erfinder: Wolff, Wilfried, 38239 Salzgitter (DE); Stege, Michael, 38446 Wolfsburg (DE)

(57) **Zusammenfassung**

Die vorliegende Verbindung betrifft ein Klebemittel für Fügeverbindungen, die sich bei Schäl- oder Schubbeanspruchung mit geringem Widerstand lösen, wobei das Klebemittel (10) mindestens eine erste Klebstoffschicht (12), mindestens eine zweite Klebstoffschicht (14) und mindestens eine die erste und die zweite Klebstoffschicht trennende Zwischenlage (13) aus einem folienartigen Material umfasst.

## Beschreibung

Die vorliegende Erfindung betrifft ein Klebemittel, umfassend mindestens eine erste Klebstoffschicht, mindestens eine zweite Klebstoffschicht und mindestens eine die erste und die zweite Klebstoffschicht trennende Zwischenlage.

Ein Klebemittel der vorgenannten Gattung ist beispielsweise in der DE 31 25 393 A1 beschrieben. Zur Verbindung zweier Wandungen einer Aufbaustruktur eines Kraftfahrzeugs werden dort jeweils flanschartige Abschnitte der Wandung übereinander gelegt und mit einem Klebemittel, umfassend ein doppelseitiges Klebeband verbunden. Dieses doppelseitige Klebeband besteht aus einer der ersten Wandung zugewandten Klebelage, einer der zweiten Wandung zugewandten Klebelage, die jeweils aus einem Wärmereaktionskleber bestehen und gegebenenfalls zusätzlich noch mit Selbstklebeschichten versehen können. Die Klebelagen sind durch ein eine Zwischenlage bildendes Textilgewebe voneinander getrennt. Die Herstellung der Fügeverbindung geschieht durch Wärmezufuhr über Heizelemente, wodurch der Wärmereaktionskleber aktiviert wird.

Aus dem Stand der Technik sind Verfahren bekannt geworden, bei denen zunächst eine Klebeverbindung zwischen zwei Bauteilen hergestellt wird, wobei Mittel vorgesehen sind, um diese Klebeverbindung später wieder zu lösen. Beispielsweise beschreibt die DE 196 21 577 A1 ein Verfahren, bei dem zunächst eine Verbindung eines Elements mit einem Bauteil über eine Klebstoffschicht bewirkt wird, wobei zwischen das Element und das Bauteil ein Schneidelement eingelegt wird, in Form eines Schneiddrahts oder dergleichen. Wenn dann eine Zugkraft auf dieses Schneidelement ausgeübt wird, wird dadurch die Klebstoffschicht durchschnitten und die Klebeverbindung getrennt.

Die DE 38 26 696 A1 beschreibt ein Verfahren zum Entfernen von durch Kleber befestigten Gegenständen von einem Untergrund, bei dem der Klebstoff unter Verlust seiner Klebrigkeit unter den Glaspunkt abgekühlt und dadurch die Klebeverbindung gelöst wird. Dies erfordert jedoch die Verwendung eines Kanals, durch den das Kühlfluid hindurchgeleitet werden kann, um die Haftkleberschicht abzukühlen. Es können auch mehrschichtige Klebebänder verwendet werden, beispielsweise doppelseitig klebende Bänder in Form von Folienbändern, die beidseitig mit einer Haftkleberschicht versehen sind, wobei auch hier Kanäle für die Durchleitung des Kühlfluids erforderlich sind, um das Klebemittel abzukühlen.

Die DE 19733643 A beschreibt eine Klebstoff-Zusammensetzung auf der Basis von mindestens einem Bindemittel, das Di- oder Polysulfidbindungen aufweist. Dadurch lassen sich lösbare Klebstoff-Zusammensetzungen formulieren, die nach herkömmlichen Methoden entweder als zweikomponenten Klebstoffe oder als einkomponentige, hitzehärtbare Klebstoffe aushärtbar sind. Derartig ausgehärtete Klebeverbindungen lassen sich mit Spaltungsagenzien auf der Basis von Mercaptoverbindungen oder auf der Basis von Reduktionsmitteln ggf. oder Hinzufügung von Quellmitteln wieder lösen. Dadurch soll es möglich werden, verklebte Bauteile auf chemischen Wege in der Klebefuge wieder zu trennen. Nachteilig bei diesem Verfahren ist die Anwendung von chemischen Spaltmitteln, die diffusionskontrolliert in die Klebefuge eindringen müssen. Derartige diffusionskontrollierte Trennungen der Klebeverbindungen sind jedoch zeitaufwendig und daher für Reparaturanwendungen weniger geeignet.

DE 19904835 A beschreibt ebenfalls Klebstoff-Zusammensetzungen, bei denen mindestens ein Bindemittel Di- oder Polysulfidbindungen aufweist. Auch in diesem Fall sollen die Klebstoffe nach herkömmlichen Methoden entweder als zweikomponenten Klebstoffe oder einkomponentige, hitzehärtbare Klebstoffe aufgebaut und aushärtbar sein. Diese Schrift schlägt vor, dass die Klebstoffmatrix bei Raumtemperatur inerte Spaltungsagenzien auf der Basis von Mercaptoverbindungen oder auf der Basis von Reduktionsmitteln eindispergiert enthält. Dabei sollen die Spaltreagenzien in kristalliner, verkapselter, chemisch blockierter, in topologisch oder sterisch inaktivierter oder in kinetisch gehemmter, feindispergierter Form vorliegen. Das Lösen der Klebeverbindungen soll dann durch das Aktivieren des in der ausgehärteten Klebstoffmischung dispergierten Spaltungsreagenzes erfolgen.

Die vorliegende Erfindung geht von der Problematik aus, dass sich eine Fügeverbindung unter Verwendung herkömmlicher Klebstoffe in der Regel bei Auftreten einer Schubbeanspruchung nicht ohne bleibende Verformung der Fügepartner lösen lässt. Wenn man daher beispielsweise im Karosseriebau zwei Fügepartner, zum Beispiel Karosseriebleche, miteinander verklebt, führen selbst elastische Klebungen mit einer vergleichsweise niedrigen Zugfestigkeit bei schneller Beanspruchung, wie sie im Falle eines Crashs auftritt, zu einer bleibenden Deformation in den verklebten Fügepartnern (Karosserieblechen).

Die Aufgabe der vorliegenden Erfindung besteht somit darin, ein Klebemittel für Fügeverbindungen der eingangs genannten Gattung zu schaffen, welches eine druckfeste Abstützklebung der Fügepartner ermöglicht, wobei sich jedoch die Klebeverbindung bei Auftreten einer Schäl- oder Schubbeanspruchung mit vergleichsweise geringem Widerstand löst. Die Lösung dieser Aufgabe liefert ein erfindungsgemäßes Klebemittel für Fügeverbindungen der eingangs genannten Gattung mit den kennzeichnenden Merkmalen des Hauptanspruchs.

Aufgabe der vorliegenden Erfindung ist es weiterhin, ein Verfahren zur Herstellung einer Fügeverbindung zwischen mindestens zwei Fügepartnern zur Verfügung zu stellen, welches die Herstellung einer druckfesten Klebeverbindung ermöglicht, die die Eigenschaft hat, sich bei Schäl- oder Schubbeanspruchung zu lösen. Die Lösung dieser Aufgabe liefert ein Verfahren mit den Merkmalen des Anspruchs 14.

Erfindungsgemäß wird mindestens eine die erste und die zweite Klebstoffschicht trennende Zwischenlage aus einem folienartigen Material verwendet. Die Eigenschaft der Klebeverbindung, sich bei Auftreten einer Schäl- oder Schubbeanspruchung mit vergleichsweise geringem Widerstand zu öffnen, hat den Vorteil, dass sich dadurch beispielsweise Karosseriebleche verkleben lassen und bei einem Crash die Klebung geöffnet wird, ohne dass es zu einer bleibenden Deformation der verklebten Karosseriebleche kommt. Dies verhindert auch eine mögliche anschließende Korrosion deformierter Bleche. Die Druckfestigkeit einer solchen erfindungsgemäßen Klebeverbindung sollte weitgehend beibehalten werden und somit einer herkömmlichen Klebeverbindung entsprechen. Da eine erfindungsgemäße Klebung auch gezielt durch Einwirkung einer Schäl- oder Schubbeanspruchung gelöst werden kann, ist sie besonders reparaturfreundlich.

Das erfindungsgemäße Klebemittel ist mehrschichtig und umfasst mindestens eine erste Klebstoffschicht, mindestens eine zweite Klebstoffschicht und mindestens eine die beiden Klebstoffschichten trennende folienartige Zwischenlage. Vorzugsweise geht zumindest einer der Klebstoffe einer der genannten Klebstoffschichten nach erfolgter Härtung keine chemische Verbindung zu der Zwischenlage ein. Die Härtung der Klebung kann beispielsweise in einem KTL-Ofen erfolgen.

Die Klebeverbindung öffnet sich vorzugsweise dadurch, dass sich mindestens eine der Klebstoffschichten von der Zwischenlage aus dem folienartigen Material löst. Verbindet man beispielsweise Karosseriebleche über eine solche Klebeverbindung, kann man erreichen, dass sich die Klebung öffnet, ohne dass sich die so verklebten Karosseriebleche deformieren. Ein Korrosionsschwachpunkt nach dem Öffnen der Klebung wird vermieden, da beide Substratflächen weiterhin mit ausreichend Klebstoff belegt sind.

Ein erfindungsgemäßes Klebemittel schafft die Möglichkeit, verschiedene Klebstoffe zu kombinieren. Man kann beispielsweise Formteile schaffen mit zwei oder mehr Klebstoffschichten aus unterschiedlich zusammengesetzten Klebstoffen. Dadurch ist es beispielsweise möglich, die Klebstoffe an die jeweiligen Oberflächen der Fügepartner anzupassen. Beispielsweise können blähfähige und nicht blähende Klebstoffe in einem Klebemittel, insbesondere in einem Formteil kombiniert werden.

Das erfindungsgemäße Klebemittel ermöglicht die Herstellung einer druckfesten Klebung, die sich bei einer definierten Schubbeanspruchung löst. Jede der mindestens zwei Klebstoffschichten kann aus selbstklebendem oder selbsthaftendem Klebstoff bestehen. Dabei ist vorzugsweise jede als Formteil herstellbare Klebstoffformulierung geeignet. Für die die Klebstoffschichten trennende Zwischenlage wird vorzugsweise eine bei der Klebstoffhärtungstemperatur nicht schrumpfende und nicht schmelzende Folie verwendet. Beispielsweise geeignet ist eine Polyesterfolie, die bei Bedarf auch mit einer antiadhäsiv wirkenden Folie ausgestattet sein kann. Die Folie kann beispielsweise auch Löcher aufweisen oder im Untermaß verwendet werden, wenn eine definierte minimale Klebung/Verbindung zwischen zwei Klebstoffschichten erzielt werden soll.

Die Klebstoffe benetzen die Folie, wobei vorzugsweise die Klebstoffschichten im ungehärteten Zustand eine Haftung zur Folienzwischenlage aufweisen. Nach erfolgter Härtung verliert vorzugsweise einer der Klebstoffe die Haftung zur Folienzwischenlage, da er zu dieser keine chemische Verbindung eingeht. Die Klebstoffe haften hingegen im ungehärteten Zustand und nach erfolgter Härtung an den Fügepartnern. Dabei können die Klebstoffe den Korrosionsschutz für die Klebeflächen auf dem zu verklebenden Substrat übernehmen, da auch nach Öffnen der Klebeverbindung der Klebstoffauftrag auf dem jeweiligen Fügepartner verbleibt.

Der Verbleib der Folie kann beispielsweise gezielt gesteuert werden, um im Reparaturfall eine einer Serie gleichwertige Klebung herstellen zu können. Die Vermeidung einer Klebung/Verbindung zwischen der verbliebenen Folie und dem Reparaturklebstoff gestattet beispielsweise eine Zweitreparatur der Klebeverbindung.

Die Folienzwischenlage kann beispielsweise auch als Gleitfläche bei Relativbewegungen zwischen den Fügepartnern dienen. Dabei wird ein Reiben beispielsweise ungeschützter Bleche gegeneinander unterbunden. Eine Korrosion kann dabei ebenfalls nicht auftreten, da beide Fügepartner weiterhin durch die Klebstoffe auf ihrer Berührungsfläche geschützt sind. Gegenstand der vorliegenden Erfindung ist insbesondere die Verwendung mindestens eines Klebemittels der vorgenannten Art zur Verbindung von Blechlagen oder im Wesentlichen aus Blechmaterial bestehenden Bauteilen. Gegenstand der Erfindung ist weiterhin insbesondere die Verwendung eines Klebemittels der vorgenannten Art für Fügeverbindungen zwischen mindestens zwei Bauteilen im Automobilbau.

Die mindestens eine erste Klebstoffschicht und/oder die mindestens eine zweite Klebstoffschicht besteht dabei vorzugsweise aus heißhärtenden, reaktiven Zusammensetzungen auf der Basis von natürlichen und / oder synthetischen Kautschuken (d.h. olefinische Doppelbindung enthaltenden Elastomeren) und Vulkanisationsmitteln, die
a) 0-10 Gew% Festkautschuk(e) mit einem Molekulargewicht von 100000 oder höher
b) 5-50 Gew% flüssige(s) Polyen(e) mit einem Molekulargewicht unter 20000
c) ein Vulkanisationssystem bestehend aus Schwefel und einem oder mehreren organischen Beschleuniger(n) und /oder Metalloxid(en)
enthalten.

Die Zusammensetzungen für die erste und/oder zweite Klebstoffschicht enthalten mindestens einen der folgenden Stoffe:
- einen oder mehrere Flüssigkautschuke und/oder Festkautschuke oder Elastomere,
- Vulkanisationsmittel, Vulkanisationsbeschleuniger, Katalysatoren,
- Füllstoffe,
- Klebrigmacher und/oder Haftvermittler,
- Treibmittel,
- Extenderöle,
- Alterungsschutzmittel,
- Rheologiehilfsmittel.

Flüssigkautschuke oder Elastomere können dabei aus der folgenden Gruppe der Homo- und/oder Copolymeren ausgewählt werden:
Polybutadiene, insbesondere die 1,4- und 1,2-Polybutadiene, Polybutene, Polyisobutylene, 1,4- und 3,4-Polyisoprene, Styrol-Butadien-Copolymere, ButadienAcrylnitril-Copolymere, wobei diese Polymeren endständige und/oder (statistisch verteilte) seitenständige funktionelle Gruppen haben können. Beispiele für derartige funktionelle Gruppen sind Hydroxy-, Amino-, Carboxyl-, Carbonsäureanhydrid- oder Epoxygruppen. Das Molekulargewicht dieser Flüssigkautschuke ist typischerweise unterhalb von 20000, vorzugsweise zwischen 900 und 10000. Der Anteil an Flüssigkautschuk an der Gesamtzusammensetzung hängt dabei von der erwünschten Rheologie der ungehärteten Zusammensetzung und den erwünschten mechanischen Eigenschaften der ausgehärteten Zusammensetzung ab. Der Anteil an flüssigem Kautschuk oder Elastomer variiert normalerweise zwischen 5 und 50 Gew.% der Gesamtformulierung. Dabei hat es sich als zweckmäßig erwiesen, vorzugsweise Mischungen von Flüssigkautschuken unterschiedlicher Molekulargewichte und unterschiedlicher Konfiguration in bezug auf die restlichen Doppelbindungen einzusetzen. Zur Erzielung optimaler Haftung auf den diversen Substraten wird in den besonders bevorzugten Formulierungen anteilig eine Flüssigkautschukkomponente mit Hydroxylgruppen bzw. Säureanhydridgruppen eingesetzt. Mindestens einer der Flüssigkautschuke sollte einen hohen Anteil an cis-1,4- Doppelbindungen, ein weiterer einen hohen Anteil an Vinyldoppelbindungen enthalten.

Geeignete Festkautschuke haben im Vergleich zu den Flüssigkautschuken ein signifikant höheres Molekulargewicht (MW=100000 oder höher), Beispiele für geeignete Kautschuke sind Polybutadien, vorzugsweise mit einem sehr hohen Anteil an cis-1,4-Doppelbindungen (typischerweise über 95%), Styrolbutadienkautschuk, Butadienacrylnitrilkautschuk, synthetischer oder natürlicher Isoprenkautschuk, Butylkautschuk oder Polyurethankautschuk.

Da die Vernetzungs- bzw. Härtungsreaktion der Kautschukzusammensetzung einen entscheidenden Einfluß auf die Zugscherfestigkeit und auf die Reißdehnung der ausgehärteten Klebstoff-Zusammensetzung hat, muß das Vulkanisationssystem besonders sorgfältig ausgewählt und abgestimmt werden. Es eignen sich eine Vielzahl von Vulkanisationssystemen sowohl auf der Basis von elementarem Schwefel als auch Vulkanisationssysteme ohne elementarem Schwefel, zu letzterem zählen die Vulkanisationssysteme auf der Basis zu Thiuramdisulfiden. Besonders bevorzugt sind Vulkanisationssysteme auf der Basis von elementarem Schwefel und organischen Vulkanisationsbeschleunigern sowie Zinkverbindungen. Der pulverförmige Schwefel wird dabei in Mengen von 0,5 bis 10 Gew.%, bezogen auf die Gesamtzusammensetzung eingesetzt, besonders bevorzugt werden Mengen zwischen 1 und 5 % eingesetzt. Als organische Beschleuniger eignen sich die Dithiocarbamate (in Form ihrer Ammonium- bzw. Metallsalze), Xanthogenate, Thiuram-Verbindungen (Monosulfide und Disulfide), Thiazolverbindungen, Aldehyd/Aminbeschleuniger (z.B. Hexamethylentetramin) sowie Guanidinbeschleuniger, ganz besonders bevorzugt wird Dibenzothiazyldisulfid (MBTS). Diese organischen Beschleuniger werden in Mengen zwischen 0 und 5 Gew.% bezogen auf die Gesamtformulierung, bevorzugt zwischen 0 und 3 %, eingesetzt. Bei den als Beschleuniger wirkenden Zinkverbindungen kann zwischen den Zinksalzen von Fettsäuren, Zinkdithiocarbamaten, basischen Zinkcarbonaten sowie insbesondere feinteiligem Zinkoxid gewählt werden. Der Gehalt an Zinkverbindungen liegt im Bereich zwischen 1 und 10 Gew.%, vorzugsweise zwischen 3 und 7 Gew.%. Zusätzlich können weitere typische Kautschukvulkanisationshilfsmittel wie z.B. Fettsäuren (z.B. Stearinsäure) in der Formulierung vorhanden sein.

Die erfindungsgemäß eingesetzten Zusammensetzungen können, falls erforderlich, Klebrigmacher und/oder Haftvermittler enthalten. Hierzu eignen sich beispielsweise Kohlenwasserstoffharze, Phenolharze, Terpen-Phenolharze, Resorcinharze oder deren Derivate, modifizierte oder unmodifizierte Harzsäuren bzw. -ester (Abietinsäurederivate), Polyamine, Polyamino-amide, Anhydride und Anhydrid- enthaltende Copolymere. Auch der Zusatz von Polyepoxidharzen in geringen Mengen (<1 Gew.%) kann bei manchen Substraten die Haftung verbessern. Hierfür werden dann jedoch vorzugsweise die festen Epoxidharze mit einem Molekulargewicht deutlich über 700 in feingemahlener Form eingesetzt, so daß die Formulierungen trotzdem im wesentlichen frei von Epoxyharzen sind, insbesondere solchen mit einem Molekulargewicht unter 700. Falls Klebrigmacher bzw. Haftvermittler eingesetzt werden, hängt deren Art und Menge von der Polymerzusammensetzung des Kleb-/ Dichtstoffes, von der gewünschten Festigkeit der gehärteten Zusammensetzung und von dem Substrat, auf welches die Zusammensetzung appliziert wird, ab. Typische klebrigmachende Harze (Tackifier) wie z.B. die Terpenphenolharze oder Harzsäurederivate, werden normalerweise in Konzentrationen zwischen 5 und 20 Gew.% verwendet, typische Haftvermittler wie Polyamine, Polyaminoamide oder Resorcinderivate werden im Bereich zwischen 0,1 und 10 Gew.% verwendet.

Zum Erzielen der Aufschäumung während des Härtungsvorganges können prinzipiell alle gängigen Treibmittel verwendet werden, vorzugsweise werden jedoch organische Treibmittel aus der Klasse der Azoverbindungen, N-Nitrosoverbindungen, Sulfonylhydrazide oder Sulfonylsemicarbazide. Für die erfindungsgemäß zu verwendenden Azoverbindungen seien beispielhaft das Azobisisobutyronitril und insbesondere das Azodicarbonamid genannt, aus der Klasse der Nitrosoverbindungen sei beispielhaft das Di-Nitrosopentamethylentetramin genannt, aus der Klasse der Sulfohydrazide das 4,4'-Oxybis(benzolsulfonsäurehydrazid), das Diphenylsulfon-3,3'-disulfohydrazid oder das Benzol-1,3-disulfohydrazid und aus der Klasse der Semicarbazide das p-Toluolsulfonylsemicarbazid genannt. An die Stelle der vorgenannten Treibmittel können auch die sogenannten expandierbare Mikrohohlkugeln ("expandable microspheres"), d.h. nicht expandierte thermoplastische Polymerpulver treten, die mit niedrigsiedenden organischen Flüssigkeiten getränkt bzw. gefüllt sind. Derartige "Microspheres" sind beispielsweise in der EP-A-559254, der EP-A-586541 oder der EP-A-594598 beschrieben. Obwohl nicht bevorzugt, können auch bereits expandierte Mikrohohlkugeln verwendet bzw. mit verwendet werden. Gegebenenfalls können diese expandierbaren / expandierten Mikrohohlkugeln in beliebigem Mengenverhältnis mit den oben genannten "chemischen" Treibmitteln kombiniert werden. Die chemischen Treibmittel werden in schäumbaren Zusammensetzungen in Mengen zwischen 0,1 und 3 Gew.%, vorzugsweise zwischen 0,2 und 2 Gew. %, die Mikrohohlkugeln zwischen 0,1 und 4 Gew. %, vorzugsweise zwischen 0,2 und 2 Gew. % verwendet.

Vorzugsweise sind die erfindungsgemäßen Zusammensetzungen frei von Weichmachern für das thermoplastische Polymer. Insbesondere sind sie frei von Phthalsäureestern. Es kann jedoch notwendig sein, die Rheologie der ungehärteten Zusammensetzung und/oder den mechanischen Eigenschaften der gehärteten Zusammensetzung durch die Zugabe von sogenannten Extenderölen, d.h. aliphatischen, aromatischen oder naphtenischen Ölen, zu beeinflussen. Vorzugsweise geschieht diese Beeinflussung jedoch durch die zweckmäßige Auswahl der niedrigmolekularen Flüssigkautschuke oder durch die Mitverwendung von niedermolekularen Polybutenen oder Polyisobutylenen. Falls Extenderöle eingesetzt werden, werden Mengen im Bereich zwischen 2 und 15 Gew.% verwendet.

Die Füllstoffe können aus einer Vielzahl von Materialien ausgewählt werden, insbesondere sind hier zu nennen Kreiden, natürliche gemahlene oder gefällte Calciumcarbonate, Calcium-Magnesium-Carbonate, Silicate, Schwerspat, Graphit sowie Ruß. Auch blättchenförmige Füllstoffe, wie z.B. Vermiculit, Glimmer, Talk oder ähnliche Schichtsilikate, sind als Füllstoffe geeignet. Es kann ggf. zweckmäßig sein, daß zumindest ein Teil der Füllstoffe oberflächenvorbehandelt ist, insbesondere hat sich bei den verschiedenen Calciumcarbonaten bzw. Kreiden eine Beschichtung mit Stearinsäure zur Verminderung der eingetragenen Feuchtigkeit und zur Verminderung der Feuchtigkeitsempfindlichkeit der ausgehärteten Zusammensetzung als zweckmäßig erwiesen. Zusätzlich enthalten die erfindungsgemäßen Zusammensetzungen in der Regel zwischen 1 und 20 Gew.%, vorzugsweise zwischen 2 und 10 Gew.%. Calciumoxid. Der Gesamtanteil an Füllstoffen in der Formulierung kann zwischen 10 und 80 Gew.% variieren, der Vorzugsbereich liegt zwischen 25 und 70 Gew.%.

Gegen den thermischen, thermooxidativen oder Ozonabbau der erfindungsgemäßen Zusammensetzungen können konventionelle Stabilisatoren wie z.B. sterisch gehinderte Phenole oder Aminderivate eingesetzt werden typische Mengenbereiche für diese Stabilisatoren sind 0,1 bis 5 Gew.%.

Obwohl die Rheologie der erfindungsgemäßen Zusammensetzungen normalerweise durch die Auswahl der Füllstoffe und das Mengenverhältnis der niedermolekularen Flüssig-Kautschuke in den gewünschten Bereich gebracht werden kann, können konventionelle Rheologiehilfsmittel wie z.B. pyrogene Kieselsäuren, Bentone oder fibrillierte oder Pulpkurzfasern im Bereich zwischen 0,1 und 7 % zugesetzt werden. Außerdem können weitere konventionelle Hilfs-und Zusatzmittel in den erfindungsgemäßen Zusammensetzungen Verwendung finden.

Das erfindungsgemäße Klebemittel wird vorzugsweise in Form von vorgefertigten mehrschichtigen Formkörpern für die Endanwendung konfektioniert. Daher wird die Rheologie der Zusammensetzungen für die erste und/oder zweite Klebstoffschicht so eingestellt, dass sich hieraus bahnenförmige oder bandförmige Formkörper extrudieren lassen, die ggf. in die passende geometrische Form durch Stanzen gebracht werden können.

Die Folienzwischenlage zwischen der ersten und zweiten Klebstoffschicht besteht dabei aus einer Kunststofffolie, hierfür kann eine gängige Kunststofffolie auf der Basis von Polyethylen, Polypropylen oder von Polyestern eingesetzt werden.

Die in den Unteransprüchen genannten Merkmale betreffen bevorzugte Weiterbildungen der erfindungsgemäßen Aufgabenlösung. Weitere Vorteile der Erfindung ergeben sich aus der nachfolgenden Detailbeschreibung.

Nachfolgend wird die vorliegende Erfindung anhand von Ausführungsbeispielen unter Bezugnahme auf die beiliegenden Zeichnungen näher beschrieben. Dabei zeigen
- Fig. 1: ein erfindungsgemäßes Klebemittel in schematisch vereinfachter perspektivischer Darstellung gemäß einer ersten Ausführungsvariante der Erfindung;
- Fig. 2: eine ähnliche Darstellung eines Klebemittels gemäß einer alternativen Variante der Erfindung;
- Fig.3: eine mittels eines erfindungsgemäßen Klebemittels hergestellte Klebstoffverbindung in perspektivischer Darstellung;
- Fig. 4: eine perspektivische Explosionsansicht eines Klebemittels gemäß einer weiteren alternativen Variante der Erfindung.

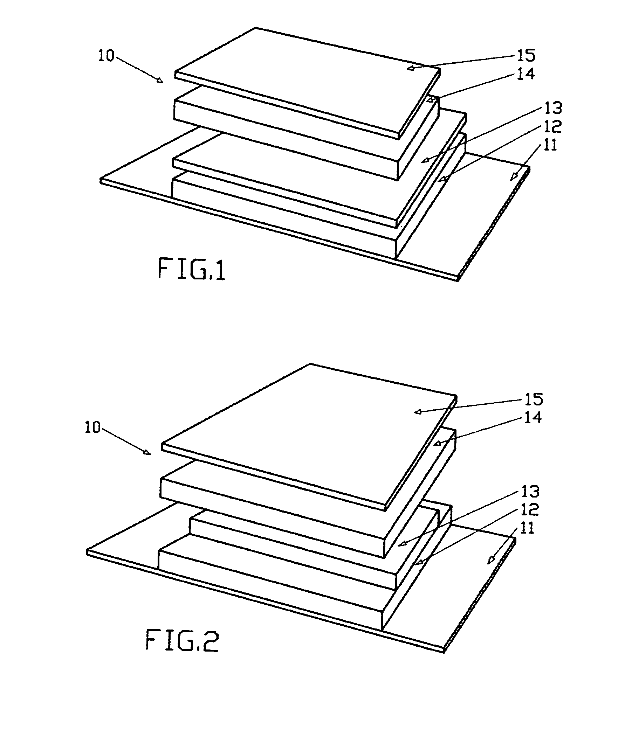

Zunächst wird auf Fig. 1 Bezug genommen. Die Darstellung zeigt in perspektivischer Explosionsdarstellung schematisch vereinfacht ein Klebemittel 10 gemäß einer ersten Variante der Erfindung. Das Klebemittel 10 umfasst eine Unterlage 11 in Form eines Trennpapiers, auf welches das Klebemittel aufgebracht ist. Auf dieses Trennpapier 11 ist zunächst eine erste Klebstoffschicht 12 aus einem ersten Klebstoff aufgebracht. Auf diese erste Klebstoffschicht 12 aufgebracht ist dann eine Zwischenlage 13 aus einem folienartigen Material. Diese Zwischenlage 13 kann optional schmaler sein als die Klebstoffschicht 12 wie man in dem vorliegenden Ausführungsbeispiel gemäß Fig. 1 erkennen kann. Auf diese Zwischenlage 13 aufgebracht ist dann eine zweite Klebstoffschicht 14. Auf diese zweite Klebstoffschicht 14 wiederum ist als obere Schicht eine Schmelzfolie 15 aufgebracht, die vorhanden sein kann, aber nicht vorhanden sein muss.

Die Schmelzfolie besteht dabei vorzugsweise aus einer Polyethylen- oder Polyestercopolymerfolie mit einem Schmelzbereich zwischen 100°C und 150°C, vorzugsweise zwischen 100°C und 120°C.

Klebstoffschichten 12 und 14 können dabei in ihrer Zusammensetzung gleich aufgebaut sein, sie können jedoch auch unterschiedlich aufgebaut sein, z.B. können sie eine unterschiedliche Blähfähigkeit aufweisen oder unterschiedliche Vernetzungsdichte (Festigkeit) im ausgehärteten Zustand.

Fig. 2 zeigt in ähnlicher perspektivischer Explosionsdarstellung ein Klebemittel 10 gemäß einer zweiten alternativen Variante der Erfindung. Auch hier ist zunächst eine untere Schicht aus einem Trennpapier 11 vorgesehen, auf die die erste Klebstoffschicht 12 aufgebracht ist. Auf dieser ersten Klebstoffschicht 12 befindet sich die Zwischenlage 13 aus dem folienartigen Material. In diesem Fall ist die Zwischenlage in ihren Abmessungen etwa deckungsgleich mit der ersten unteren Klebstoffschicht 12. Auf die folienartige Zwischenlage 13 ist wiederum die zweite Klebstoffschicht 14 aus einem zweiten Klebstoff aufgebracht, der gegenüber dem ersten Klebstoff der Klebstoffschicht 12 andersartig sein kann. In dem vorliegenden Ausführungsbeispiel gemäß Fig. 2 ist die zweite Klebstoffschicht 14 etwas kleiner und somit nicht deckungsgleich mit den Abmessungen der Zwischenlage 13. Auf diese zweite Klebstoffschicht 14 ist dann wiederum eine Lage aus einer Schmelzfolie 15 aufgebracht, die in dem Ausführungsbeispiel gemäß Fig. 2 den Abmessungen der zweiten Klebstoffschicht entspricht.

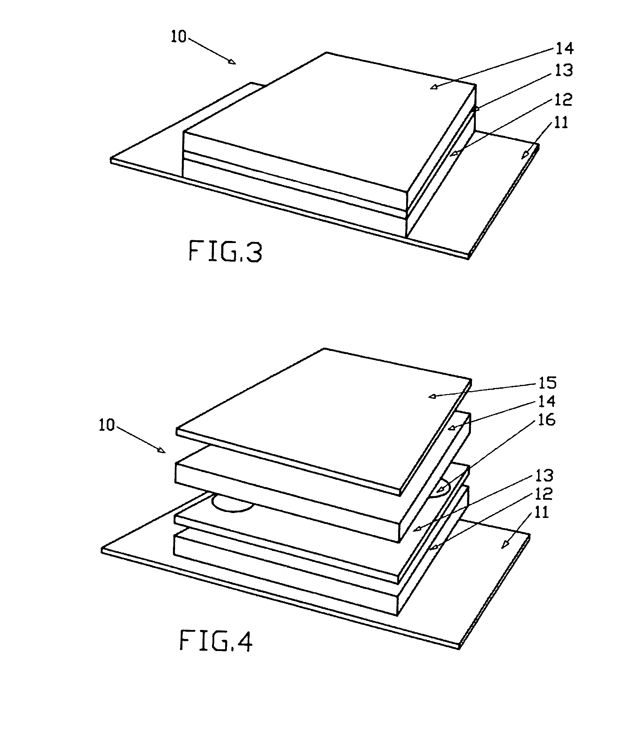

Fig. 3 zeigt ein drittes Ausführungsbeispiel gemäß der Erfindung, wobei hier in perspektivischer Darstellung die einzelnen Schichten aufeinanderliegend dargestellt sind. Das Klebemittel gemäß Fig. 3, welches insgesamt mit 10 bezeichnet ist, umfasst eine untere Schicht 11 aus einem Trennpapier, auf die eine erste Klebstoffschicht 12 aufgebracht ist. Darüber befindet sich eine Zwischenlage 13 aus einem folienartigen Material. Auf diese Zwischenlage 13 ist dann die zweite Klebstoffschicht 14 aufgebracht. In dem Ausführungsbeispiel gemäß Fig. 3 ist die zuvor beschriebene Schmelzfolie 15 nicht vorhanden.

Fig. 4 zeigt eine weitere alternative Ausführungsvariante eines erfindungsgemäßen Klebemittels, wobei dieses wiederum in einer perspektivischen Explosionsansicht dargestellt ist. Auch hier ist zunächst eine untere Lage aus einem Trennpapier 11 vorgesehen, auf die die erste Klebstoffschicht 12 aufgebracht ist. Auf diese erste Klebstoffschicht 12 ist die Zwischenlage 13 aus dem folienartigen Material aufgebracht, wobei in diesem Ausführungsbeispiel diese Zwischenlage Löcher 16 aufweist. Durch derartige Löcher kann man erreichen, dass eine definierte minimale KlebungNerbindung zwischen der unteren Klebstoffschicht 12 und der darüber liegenden zweiten Klebstoffschicht 14 erzielt werden kann. Sind keine solchen Löcher vorhanden und wird die die Zwischenlage 13 bildende Folie auch nicht im Untermaß verwendet, dann ist über die Folienzwischenlage eine Gleitfläche gegeben, die Relativbewegungen zwischen den mittels der Klebemittel verbundenen Fügepartnern ermöglicht.

Die erfindungsgemäßen Klebemittel können dabei entweder wie vorstehend anhand der Figuren 1 bis 4 skizziert, als mehrschichtige Formteile hergestellt werden, die dann bei der Endanwendung von der als Trennfolie oder Trennpapier ausgebildeten Unterlage 11 befreit werden und somit der ggf. im ungehärteten Zustand Eigenklebrigkeit aufweisenden ersten Klebstoffschicht 12 auf das eine zufügende Substrat aufgebracht werden. Es folgt das Fügen mit dem 2. Substrat und anschließendes Aushärten der Klebstoffschichten im weiteren Fertigungsprozess der Automobilfertigung, insbesondere im Lack-Ofen nach der kathodischen Tauchlackierung (KTL-Ofen).

Bevorzugte Anwendungen für die erfindungsgemäßen Klebemittel sind dabei linienförmige oder nahezu punktförmige Klebungen, die ein hochelastisches Verhalten bei Zug-, Scher- oder Schälbelastung aufweisen. Bei Zug-, Scher- oder Schälbelastung öffnet sich die Klebung zwischen den verklebten Substraten ohne Beschädigung der Fügepartner. Mit derartigen Klebungen abgestützte Bauteile behalten ihre Stabilität in Bezug auf eine Druckbelastung, beispielsweise werden Kotflügel so an dem Karosseriekörper unterstützend gefügt. Bei Demontage im Reparaturfall können derart abgestützte Bauteile beschädigungsfrei abgenommen werden.

Bevorzugt werden derartige Klebemittel in kleinflächiger Anwendung appliziert, bevorzugte Abmessungen haben etwa die Größe von Briefmarken, das heißt, 1,5 bis 10 cm, vorzugsweise 1,5 bis 3 cm lineare Ausdehnung einer Kante der Fläche. Dabei können diese schichtförmigen Klebemittel als quadratische, rechteckige, runde oder elliptische Formkörper ausgebildet sein. Es ist jedoch auch möglich, das Klebemittel direkt vor Ort bei der Montage zu erzeugen. Dazu wird die Klebstoffschicht 12 bzw. 14 direkt durch Raupenauftrag auf die zufügenden Substratteile aufgebracht und auf eine dieser aufgebrachten Klebstoffraupen wird dann eine Zwischenlage 13 mit geeigneter Abmessung aufgebracht, woran sich das Fügen der Substratteile anschließt.

### Bezugszeichenliste

- 10: Klebemittel
- 11: Unterlage
- 12: erste Klebstoffschicht
- 13: Zwischenlage
- 14: zweite Klebstoffschicht
- 15: Schmelzfolie
- 16: Löcher in der Zwischenlage

## Patentansprüche

1. Klebemittel für Fügeverbindungen, umfassend mindestens eine erste Klebstoffschicht, mindestens eine zweite Klebstoffschicht und mindestens eine die erste und die zweite Klebstoffschicht trennende Zwischenlage,
**dadurch gekennzeichnet, dass** die mindestens eine Zwischenlage ein folienartiges Material umfasst,
und/oder das Klebemittel ein mindestens teilweises mindestens einseitiges Lösen der Fügeverbindung zu einem der Fügepartner bei Einwirkung einer Schäl- und/oder Schubbeanspruchung zulässt.

2. Klebemittel nach Anspruch 1, **dadurch gekennzeichnet, dass** dieses mindestens eine Klebstoffschicht aus einem selbstklebenden oder selbsthaftenden Klebstoff aufweist.

3. Klebemittel nach Anspruch 1 oder 2, **dadurch gekennzeichnet, dass** mindestens eine Klebstoffschicht einen bei erhöhter Temperatur härtenden Klebstoff umfasst.

4. Klebemittel nach einem der Ansprüche 1 bis 3 enthaltend als Klebstoff heißhärtende, reaktive Zusammensetzungen auf der Basis von natürlichen und /oder synthetischen Kautschuken (d.h. olefinische Doppelbindung enthaltenden Elastomeren) und Vulkanisationsmitteln.

5. Klebemittel nach einem der Anspruch 4, **dadurch gekennzeichnet, dass** der heißhärtende Klebstoff
a) 0-10 Gew% Festkautschuk(e) mit einem Molekulargewicht von 100000 oder höher
b) 5-50 Gew% flüssige(s) Polyen(e) mit einem Molekulargewicht unter 20000
c) ein Vulkanisationssystem bestehend aus Schwefel und einem oder mehreren organischen Beschleuniger(n) und /oder Metalloxid(en)
enthält.

6. Klebemittel nach einem der Ansprüche 1 bis 5, **dadurch gekennzeichnet, dass** mindestens eine Klebstoffschicht im ungehärteten Zustand Haftung zur Zwischenlage aus dem folienartigen Material aufweist.

7. Klebemittel nach einem der Ansprüche 1 bis 6, **dadurch gekennzeichnet, dass** mindestens eine Klebstoffschicht nach Härtung des Klebstoffs die Haftung zur Zwischenlage aus dem folienartigen Material verliert.

8. Klebemittel nach einem der Ansprüche 1 bis 7, **dadurch gekennzeichnet, dass** die Zwischenlage eine bei Klebstoffhärtungstemperatur nicht schrumpfende und/oder nicht schmelzende Folie umfasst.

9. Klebemittel nach einem der Ansprüche 1 bis 8, **dadurch gekennzeichnet, dass** die Zwischenlage eine Polyesterfolie umfasst.

10. Klebemittel nach einem der Ansprüche 1 bis 9, **dadurch gekennzeichnet, dass** die Zwischenlage ein folienartiges Material umfasst, welches mit mindestens einer antiadhäsiv wirkenden Schicht ausgestattet ist.

11. Klebemittel nach einem der Ansprüche 1 bis 10, **dadurch gekennzeichnet, dass** das die Zwischenlage bildende folienartige Material Löcher oder Aussparungen aufweist.

12. Klebemittel nach einem der Ansprüche 1 bis 11, **dadurch gekennzeichnet, dass** das die Zwischenlage bildende folienartige Material bezüglich auf den Umriss mindestens einer der Klebstoffschichten im Untermaß verwendet wird.

13. Klebemittel nach einem der Ansprüche 1 bis 12, **dadurch gekennzeichnet, dass** das die Zwischenlage bildende folienartige Material als Gleitfläche ausgebildet ist, die Relativbewegungen zwischen den mittels der Klebstoffschichten verbundenen Fügepartnern ermöglicht.

14. Klebemittel nach einem der Ansprüche 1 bis 12, **dadurch gekennzeichnet, dass** mindestens eine der Klebstoffschichten mindestens teilweise durch eine Schmelzfolie abgedeckt ist.

15. Klebemittel nach einem der Ansprüche 1 bis 14, **dadurch gekennzeichnet, dass** mindestens eine Klebstoffschicht beziehungsweise das Klebemittel auf eine Unterlage aufgebracht ist, die ein Trennpapier umfasst.

16. Verfahren zur Herstellung einer Fügeverbindung zwischen mindestens zwei Fügepartnern, **dadurch gekennzeichnet, dass** in diesem zur Herstellung der Fügeverbindung mindestens ein Klebemittel gemäß einem der Ansprüche 1 bis 15 verwandt wird.

17. Verwendung mindestens eines Klebemittels gemäß einem der Ansprüche 1 bis 15 zur Verbindung von Blechlagen oder im Wesentlichen aus Blechmaterial bestehenden Bauteilen.

18. Verwendung nach Anspruch 17 für Fügeverbindungen zwischen mindestens zwei Bauteilen im Automobilbau.
